(19) Europäisches Patentamt
European Patent Office
Office européen des brevets

(11) **EP 4 632 407 A1**

(12) **EUROPEAN PATENT APPLICATION**
published in accordance with Art. 153(4) EPC

(43) Date of publication:
**15.10.2025 Bulletin 2025/42**

(21) Application number: **23924882.6**

(22) Date of filing: **24.08.2023**

(51) International Patent Classification (IPC):
**G01R 31/389** (2019.01)    **G01R 31/392** (2019.01)
**H02J 7/34** (2006.01)

(52) Cooperative Patent Classification (CPC):
Y02E 60/10

(86) International application number:
**PCT/CN2023/114787**

(87) International publication number:
**WO 2024/178925 (06.09.2024 Gazette 2024/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.03.2023 CN 202310215706**

(71) Applicant: **Hefei Gotion High-Tech Power Energy Co., Ltd.**
**Hefei, Anhui 230012 (CN)**

(72) Inventors:
• **LU, Kai**
**Hefei, Anhui 230012 (CN)**
• **CHEN, Xiaohu**
**Hefei, Anhui 230012 (CN)**
• **CHENG, Qianqian**
**Hefei, Anhui 230012 (CN)**

(74) Representative: **Studio Torta S.p.A.**
**Via Viotti, 9**
**10121 Torino (IT)**

(54) **INTERNAL-RESISTANCE CONSISTENCY-BASED FAULT RECOGNITION METHOD FOR ENERGY STORAGE BATTERY, AND ENERGY STORAGE SYSTEM**

(57) A method for identifying an internal resistance consistency fault in an energy storage battery and an energy storage system are provided. The method for identifying an internal resistance consistency fault in an energy storage battery comprises: setting an upper limit of cell internal resistance deviation threshold; determining a relationship expression of reference internal resistance of a cell with respect to a reference temperature and reference capacity of the cell; acquiring external circuit resistance of each battery cell and current cell internal resistance; determining, according to the external circuit resistance and the current cell internal resistance, actual cell internal resistance; acquiring reference internal resistance of each cell under the reference temperature and reference capacity conditions; comparing actual cell internal resistance of cells with a same serial number in different battery modules with reference internal resistance of the cells with the same serial number to obtain an internal resistance deviation value; and determining whether the internal resistance deviation value is greater than the cell internal resistance deviation threshold, and determining, in response to the internal resistance deviation value being greater than the cell internal resistance deviation threshold, that the cell is faulty. The method for identifying an internal resistance consistency fault in an energy storage battery can enhance the accuracy of battery fault determination and significantly enhance system safety.

EP 4 632 407 A1

setting an upper limit of a cell internal resistance deviation threshold

determining a relationship expression of a reference internal resistance of a cell with respect to a reference temperature and a reference capacity of the cell

acquiring an external circuit resistance and current cell internal resistance of each battery cell

determining, according to the external circuit resistance and the current cell internal resistance of the each battery cell, an actual cell internal resistance of the each battery cell

acquiring the reference internal resistance of the cell under the reference temperature and reference capacity conditions

comparing actual cell internal resistances of cells with a same serial number in different battery modules with the reference internal resistances of the cell with the same serial number to obtain an internal resistance deviation value

determining whether the internal resistance deviation value is greater than the cell internal resistance deviation threshold, and determining, in response to the internal resistance deviation value being greater than the cell internal resistance deviation threshold, that the cell is faulty

FIG. 1

## Description

This application claims priority to Chinese Patent Application No. 202310215706.9, titled "METHOD FOR IDENTIFYING INTERNAL RESISTANCE CONSISTENCY FAULT IN ENERGY STORAGE BATTERY AND ENERGY STORAGE SYSTEM", filed on March 2, 2023.

## Technical Field

The present invention relates to the field of battery technology, and particularly, to a method for identifying an internal resistance consistency fault in an energy storage battery and an energy storage system.

## Background

An energy storage system includes at least a plurality of battery modules, each of which is composed of numerous battery cells connected in series or in parallel. Each battery module is equipped with a battery management system, which is configured to collect voltage, current, and temperature information of the battery module, estimate the state of charge (SOC) and state of health (SOH) of the battery, and perform fault identification and determination on cells.
A method for evaluating the consistency safety status of a power battery is disclosed in the related art. A large amount of historical operation data of the vehicle to be evaluated is acquired. For each charging data segment, a standard deviation feature and a variance entropy consistency feature of the cell voltage are calculated to obtain feature values. The number of charge-discharge cycles is also acquired. The feature values are then constructed into a feature matrix, which is subjected to unsupervised training using a preset algorithm to generate a confusion matrix. A quantitative calculation model for the consistency safety status of the power battery is constructed according to the confusion matrix. Through this quantitative evaluation for the consistency safety status of the power battery, risk factors are able to be intuitively identified and analyzed from a large volume of historical operation data. This method requires dynamically identifying historical voltage difference data of a vehicle and using the voltage difference data as a basis for determination, thereby identifying the risk factors in the historical data. However, for a cell, voltage is a superficial parameter that is able to be directly collected by the BMS during operation of a battery cell. The essence of voltage lies in that when current flows through the battery cell, a voltage drop is generated across the two terminals of the battery cell. Therefore, the voltage is affected by the temperature and capacity of the battery cell. At higher temperatures, ions inside the battery cell become more active, resulting in lower internal resistance. Conversely, a higher capacity leads to greater resistance to ion flow through the battery cell, resulting in higher internal resistance. Additionally, when a battery cell is about to become faulty, its internal resistance typically changes first. Thus, internal resistance of the battery cell is the fundamental cause of voltage variations.
The energy storage system is composed of a plurality of battery packs connected in series or in parallel. Each battery pack shares the same internal structure. However, due to differences in installation location and variations in the effectiveness of a cooling system, ambient temperatures of different battery packs are not uniform. Moreover, within each battery pack, the temperature variation is even more pronounced. Typically, battery cells located in the center of the battery pack experience the highest temperatures due to the accumulation of radiant heat, with the heat gradually diffusing outward. In general, the temperature variation in the energy storage system is able to reach 3 to 10°C. Such a large temperature variation causes variations in the internal resistance of the battery cell. As a result, the voltage differences of the battery cell also change, making accurate fault determination difficult.

## Summary

A primary object of the present invention is to provide a method for identifying an internal resistance consistency fault in an energy storage battery and an energy storage system. This method is able to avoid incorrect and delayed battery fault determination, enable timely identification of a problematic battery cell before fault occurrence, enhance the accuracy of battery fault determination, and significantly enhance system safety.
To achieve the object above, according to one aspect of the present invention, there is provided a method for identifying an internal resistance consistency fault in an energy storage battery, the method including:

setting an upper limit of a cell internal resistance deviation threshold;

determining a relationship expression of a reference internal resistance of a cell with respect to a reference temperature and a reference capacity of the cell;

acquiring an external circuit resistance and current cell internal resistance of each battery cell;

determining, according to the external circuit resistance and the current cell internal resistance of the each battery cell, an actual cell internal resistance of the each battery cell;

acquiring the reference internal resistance of each of the cells under the reference temperature and reference capacity conditions;

comparing actual cell internal resistances of cells with a same serial number in different battery modules with the reference internal resistances of the cells with the same serial number to obtain an internal resistance deviation value; and

determining whether the internal resistance deviation value is greater than the cell internal resistance deviation threshold, and determining, in response to the internal resistance deviation value being greater than the cell internal resistance deviation threshold, that the cell is faulty.

In an embodiment, a step of determining the relationship expression of reference internal resistance of the cell with respect to the reference temperature and the reference capacity of the cell includes:

setting the reference temperature $T\_b$ and reference capacity $SOC\_b$ of the cell as two independent variables, and the reference internal resistance $R\_b$ of the cell as a dependent variable; and

acquiring a relationship expression of the reference internal resistance $R\_b$ with respect to the reference temperature $T\_b$ and the reference capacity $SOC\_b$:

$$R\_b = p1 + p2 * Exp(-T\_b / p3) * Exp(-SOC\_b / p4),$$

wherein p1, p2, p3, and p4 are constants obtained through experiments or empirical formulas.

In an embodiment, a step of acquiring the relationship expression of the reference internal resistance $R\_b$ with respect to the reference temperature $T\_b$ and the reference capacity $SOC\_b$ includes:

conducting evenly spaced experiments on the cell within a preset operating environment;

varying, using a single temperature as an horizontal axis, the capacity at equal intervals, and measuring reference internal resistance at different capacities under the temperature;

adjusting the temperature, varying the capacity at equal intervals again, and measuring reference internal resistance at different capacities under the temperature;

repeating the steps above to obtain an array relationship table of the reference internal resistance $R\_b$ with respect to the reference temperature $T\_b$ and the reference capacity $SOC\_b$, a fundamental functional model thereof being:

$$R\_b = f(T\_b) * g(SOC\_b) + C,$$

wherein C represents a constant; and

using least squares method in matlab to fit experimental data to acquire the relationship expression of the reference internal resistance $R\_b$ with respect to the reference temperature $T\_b$ and the reference capacity $SOC\_b$.

In an embodiment, a step of acquiring the external circuit resistance of the each battery cell includes:

acquiring a tested cell internal resistance $R_i$ of the each battery cell under a same test condition;

collecting a battery cell voltage set of the battery modules as $[V_{1i}, V_{2i}, V_{3i}, ..., V_{ni}]$, wherein n represents an n-th battery module, and i represents an i-th battery cell within a battery module; and

calculating the external circuit resistance of the battery cell as $R_{ni} = (V_{ni} - I_n * R_i) / I_n$, wherein $I_n$ represents a current of the battery cell in the n-th battery module.

In an embodiment, the step of the acquiring external circuit resistance of each battery cell further includes:

acquiring external circuit resistances of a same battery cell under $\beta$ test conditions; and

calculating an average external circuit resistance as $Rni\_o = (Rni\_1 + Rni\_2 + ... + Rni\_\beta) / \beta$, and using $Rni\_o$ as the external circuit resistance of the i-th battery cell in the n-th battery module.

In an embodiment, a step of acquiring reference internal resistance of each cell under the reference temperature and reference capacity conditions includes:

acquiring a current temperature and a current battery capacity of a battery cell within each battery module; and

calculating the reference internal resistance of each of the cells under the reference capacity and reference temperature conditions:

$$R\_b\_i = p1 + p2 * Exp(-T\_b\_i / p3) * Exp(-SOC\_b\_i / p4),$$

wherein $T\_b\_i$ represents an average current temperature of cells with a same serial number in all battery modules, and $SOC\_b\_i$ represents an average current capacity of the cells with the same serial number in all battery modules.

In an embodiment, a step of comparing the actual cell internal resistances of the cells with a same serial number in different battery modules with the reference internal resistances of the cells with the same serial number to obtain an internal resistance deviation value includes:

Sorting the actual cell internal resistances $R\_tr$ of cells i with a same serial number in all battery modules in ascending order, and acquiring a maximum value and a minimum value, $R\_tr\_i\_max$ and $R\_tr\_i\_min$; and

calculating a maximum internal resistance deviation value $MAX_i$ of the actual cell internal resistances $R\_tr\_i$ of cells i with a same serial number relative to the reference internal resistances $R\_b$: $MAX_i = max\ [|R\_tr\_i\_max - R\_bl, |R\_b - R\_tr\_i\_min|]$.

In an embodiment, $\beta$ test conditions are test conditions formed under a same ambient temperature with $\beta$ different capacities.

According to another aspect of the present invention, there is provided an energy storage system applying the method for identifying an internal resistance consistency fault in an energy storage battery described above, the energy storage system including:

n battery modules connected in parallel, wherein each battery module includes a BMS and a plurality of cells, and the plurality of cells are connected in series and/or in parallel; and

a microgrid controller communicatively connected with each BMS, wherein the microgrid controller is configured to acquire battery module parameters collected by each BMS and to process the battery module parameters.

In an embodiment, the energy storage system further includes an energy storage converter, wherein the energy storage converter is connected with all of the battery modules and configured to control charging and discharging of the battery modules; and/or, the energy storage converter is electrically connected with the microgrid controller, wherein when the microgrid controller detects a fault in the cells, the microgrid controller issues a shutdown command to the energy storage converter to stop charging and discharging the battery modules.

Applying the technical solution of the present invention, the method for identifying an internal resistance consistency fault in an energy storage battery includes: setting an upper limit of a cell internal resistance deviation threshold; determining a relationship expression of reference internal resistance of a cell with respect to a reference temperature and reference capacity of the cell; acquiring an external circuit resistance and current cell internal resistance of each battery cell; determining, according to the external circuit resistance and the current cell internal resistance of the each battery cell, an actual cell internal resistance of the battery cell; acquiring reference internal resistance of the cell under the reference temperature and reference capacity conditions; comparing actual cell internal resistances of cells with a same serial number in different battery modules with reference internal resistances of the cells with the same serial number to obtain an internal resistance deviation value; and determining whether the internal resistance deviation value is greater than the cell internal resistance deviation threshold, and determining, in response to the internal resistance deviation value being greater than the cell internal resistance deviation threshold, that the cell is faulty. The method for identifying an internal resistance consistency fault in an energy storage battery utilizes a characteristic that the internal resistance of a battery cell increases before fault occurrence as the basis for fault determination. This method thoroughly accounts for various influencing factors of internal resistance and eliminates the external circuit resistance of the battery cell from the collected data. Further, this method compares battery cells in the same position across different battery modules, ensuring that the battery cells being compared are under the same position, operating environment, temperature, and capacity conditions. This enables precise calculation of the actual cell internal resistance of the battery cells, thereby enhancing the accuracy of fault determination and significantly enhancing system safety.

## Brief Description of the Drawings

The drawings, which constitute part of the present invention, are intended to provide a further understanding of the present invention. The schematic embodiments of the present invention and the description thereof are intended to explain, rather than unduly limit, the present invention. In the drawings:

FIG. 1 shows a schematic diagram of a method for identifying an internal resistance consistency fault in an energy storage battery according to an embodiment of the present invention; and

FIG. 2 shows a structural diagram of an energy storage system according to an embodiment of the present invention.

## Detailed Description of the Embodiments

It is to be noted that, unless there is a conflict, embodiments of the present invention and features in the embodiments may be combined with each other. The present invention is described in detail below with reference to the drawings and in conjunction with the embodiments.

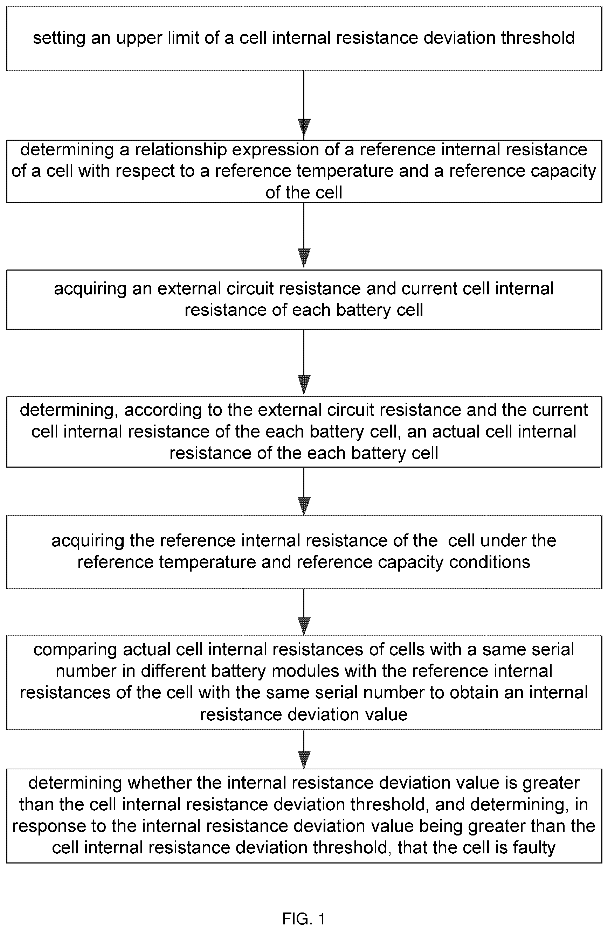

Referring to FIG. 1, the present invention provides a method for identifying an internal resistance consistency fault in an energy storage battery, the method including: setting an upper limit of a cell internal resistance deviation threshold; determining a relationship expression of a reference internal resistance of a cell with respect to a reference temperature and a reference capacity of the cell; acquiring an external circuit resistance and current cell internal resistance of each battery cell; determining, according to the external circuit resistance and the current cell internal resistance of the each battery cell, an actual cell internal resistance of the each battery cell; acquiring the reference internal resistance of the cell under the reference temperature and reference capacity conditions; comparing actual cell internal resistances of cells with a same serial number in different battery modules with reference internal resistances of the cells with the same serial number to obtain an internal resistance deviation value; and determining whether the internal resistance deviation value is greater than the cell internal resistance deviation threshold, and determining, in response to the internal resistance deviation value being greater than the cell internal resistance deviation threshold, that the cell is faulty.

The method for identifying the internal resistance consistency fault in the energy storage battery utilizes a characteristic that the internal resistance of a battery cell increases before fault occurrence as the basis for fault determination. This method thoroughly accounts for various influencing factors of internal resistance and eliminates the external circuit resistance of the battery cell from the collected data. Further, this method compares battery cells in the same position across different battery modules, ensuring that the battery cells being compared are under the same position, operating environment, temperature, and capacity conditions. This enables precise calculation of the actual cell internal resistance of the battery cells, thereby enhancing the accuracy of fault determination and significantly enhancing system safety.

In an embodiment, in a step of setting the upper limit of the cell internal resistance deviation threshold, the upper limit of the cell internal resistance deviation threshold may be determined by simulating a temperature rise and a voltage drop response caused by an increase in the cell internal resistance, using cell characteristic experiments.

In an embodiment, a step of determining the relationship expression of reference internal resistance of the cell with respect to the reference temperature and the reference capacity of the cell includes: setting the reference temperature $T\_b$ and the reference capacity $SOC\_b$ of the cell as two independent variables, and the reference internal resistance $R\_b$ of the cell as a dependent variable; and acquiring a relationship expression of the reference internal resistance $R\_b$ with respect to the reference temperature $T\_b$ and the reference capacity $SOC\_b$: $R\_b = p1 + p2 * Exp(-T\_b / p3) * Exp(-SOC\_b / p4)$, wherein p1, p2, p3, and p4 are constants obtained through experiments or empirical formulas.

In this embodiment, by setting the reference temperature $T\_b$ and the reference capacity $SOC\_b$ of the cell as the two independent variables, and the reference internal resistance $R\_b$ of the cell as the dependent variable, the variation of the reference internal resistance $R\_b$ of the cell is able to be associated with variations of the reference temperature $T\_b$ and the reference capacity $SOC\_b$ of the cell. Thus, the corresponding reference internal resistance $R\_b$ is able to be determined according to the variations of the reference temperature T_b and the reference capacity SOC_b of the cell. The reference temperature T_b herein refers to an actually measured current temperature of the cell during internal resistance consistency fault identification in the energy storage battery. The reference capacity SOC_b refers to an actually measured current capacity of the cell during internal resistance consistency fault identification in the energy storage battery. The reference internal resistance R_b refers to a theoretically expected internal resistance of the cell, in a normal state, under the reference temperature T_b and the reference capacity SOC_b conditions. This reference internal resistance R_b is able to serve as a reference for determining whether the actual cell internal resistance deviates excessively during an actual operation of the cell. Therefore, it can be determined whether the deviation amplitude of the actual cell internal resistance exceeds ta preset range and whether a fault has occurred.

After acquiring the relationship expression of the reference internal resistance R_b with respect to the reference temperature T_b and the reference capacity SOC_b, the reference internal resistance R_b under a given reference temperature T_b and reference capacity SOC_b is able to be directly calculated applying the formula above. This eliminates a need for additional measurements or calculations, thereby significantly enhancing the efficiency of fault determination and reducing the complexity of internal resistance comparison.

In an embodiment, a step of acquiring the relationship expression of the reference internal resistance R_b with respect to the reference temperature T_b and the reference capacity SOC_b includes: conducting evenly spaced experiments on the cell within a preset operating environment; varying, using a single temperature as a horizontal axis, the capacity at equal intervals, and measuring reference internal resistances at different capacities under the temperature; adjusting the temperature, varying the capacity at equal intervals again, and measuring reference internal resistances at different capacities under the temperature; repeating the steps above to obtain an array relationship table of the reference internal resistance R_b with respect to the reference temperature T_b and the reference capacity SOC_b, a fundamental functional model thereof being: R_b = f(T_b) * g(SOC_b) + C, wherein C represents a constant; and using least squares method in matlab to fit experimental data to acquire the relationship expression of the reference internal resistance R_b with respect to the reference temperature T_b and the reference capacity SOC_b.

In this embodiment, a specific process of acquiring the relationship expression of the reference internal resistance R_b with respect to the reference temperature T_b and the reference capacity SOC_b is as follows:

establishing two independent variables, setting the reference temperature T_b and reference capacity SOC_b of the cell of the battery cell as two independent variables, and the reference internal resistance R_b of the cell as the dependent variable; conducting evenly spaced experiments on the battery cell within a normal operating environment, wherein an ambient temperature condition is T_tr[T1-T2], and a capacity condition is SOC_tr[0%-100%], that is, varying, using a single temperature as the horizontal axis, the capacity at equal intervals, and measuring reference internal resistance under a temperature and capacity; then varying the temperature again, varying the capacity at equal intervals again, and measuring reference internal resistance under another temperature and capacity; measuring a plurality of groups of data to obtain an array relationship table of the reference internal resistance R_b with respect to the reference temperature T_b and the reference capacity SOC_b, a fundamental functional model thereof being:

$$R\_b = f(T\_b) * g(SOC\_b) + C;$$

and

using least squares method in matlab to fit experimental data to acquire the relationship expression of the reference internal resistance R_b with respect to the reference temperature T_b and the reference capacity SOC_b:

$$R\_b = p1 + p2 * Exp(-T\_b / p3) * Exp(-SOC\_b / p4),$$

wherein p1, p2, p3, and p4 are constants.

In this embodiment, the ambient temperature condition is T_tr[5-50], that is, the ambient temperature range is 5°C to 50°C. However, other temperature ranges may also be adopted depending on the specific temperature conditions of the invention environment of the battery. The capacity condition SOC_tr[0%-100%] refers to the traversal of the capacity from 0% to 100%, thereby acquiring the reference internal resistances corresponding to different capacity segments under the same temperature.

In an embodiment, a step of acquiring external circuit resistance of each battery cell includes: acquiring a tested cell internal resistance Ri of the each battery cell under a same test condition; collecting an battery cell voltage set of the battery modules as $[V_{1i}, V_{2i}, V_{3i}, ..., V_{ni}]$, wherein n represents an n-th battery module, and i represents an i-th battery cell within a battery module; and calculating the external circuit resistance of the battery cell as $R_{ni} = (V_{ni} - I_n * R_i) / I_n$, wherein $I_n$ represents a current of the battery cell in the n-th battery module.

In this embodiment, taking the series connection of battery cells within the same battery module as an example, each battery module is composed of i battery cells connected in series. In this case, a tested cell internal resistance $R_i$ of each battery cell under a same test condition is able to be acquired. Then, using the tested cell internal resistance $R_i$ and the internal resistance of the battery cell, the external circuit resistance corresponding to each cell is able to be calculated. Since the external circuit resistance remains substantially constant, the calculated external circuit resistance at any given time is generally consistent. On the basis of this, the external circuit resistance is able to be calculated under initial factory conditions of the battery module. In this case, all cells within the battery module are in initial states and have been verified to be normal. Therefore, it can be assumed that the tested cell internal resistance of the battery cell obtained through individual testing is consistent with the actual cell internal resistance of the battery cell within the battery module. Accordingly, the external circuit resistance calculated in this manner is considered to be accurate.

An battery cell includes a cell and an external circuit connected with the cell. The internal resistance of the battery cell above is a sum of the tested cell internal resistance Ri and the external circuit resistance. Therefore, after obtaining the tested cell internal resistance Ri and the internal resistance of the battery cell, the difference between the two represents the external circuit resistance corresponding to the cell.

After acquiring the accurate tested cell internal resistance $R_i$, the external circuit resistance corresponding to the cell is able to be calculated according to the directly measured internal resistance of the each battery cell. The internal resistance of the battery cell is able to be calculated according to the cell voltage. Since battery cells in each battery module are connected in series, the current $I_n$ of the cells within the same battery module is identical. On the basis of this, the external circuit resistance is able to be calculated as $R_{ni} = V_{ni} / I_n - R_i = (V_{ni} - I_n * R_i) / I_n$. In this way, a relatively accurate external circuit resistance $R_{ni}$ corresponding to each cell can be calculated.

For a structure in which the battery module includes a plurality of parallel-connected battery strings, and each battery string including i battery cells, the calculation method above is equally applicable. The difference lies in the calculation of the current for each battery cell, which needs to be determined by dividing the total current of each battery module by the number of parallel-connected battery strings. Other calculation methods are essentially the same as those described above.

In an embodiment, the step of acquiring the external circuit resistance of each battery cell further includes: acquiring external circuit resistances of a same battery cell under $\beta$ test conditions; and calculating an average external circuit resistance as $Rni\_o = (Rni\_1 + Rni\_2 + ... + Rni\_\beta) / \beta$, and using Rni_o as the external circuit resistance of the i-th battery cell in the n-th battery module.

Since the fluctuation of the cell internal resistance is affected by various test conditions, the tested cell internal resistance Ri may fluctuate and may not fully conform to the fluctuation variation rule of the cell internal resistance with respect to the temperature or capacity. However, the external circuit resistance is not affected by the temperature and capacity of the cell, or these effects are able to be completely ignored. Therefore, by altering the test conditions, the external circuit resistances corresponding to the same battery cell under different test conditions are able to be calculated. Furthermore, the average of the calculated external circuit resistance values corresponding to the same battery cell under different test conditions is then able to be used to reduce the impact of fluctuations in the cell internal resistance on the external circuit resistance calculation. This allows for a more accurate external circuit resistance, thereby further enhancing the accuracy of internal resistance consistency fault identification in an energy storage battery.

In an embodiment, $\beta$ test conditions are test conditions formed under a same ambient temperature with $\beta$ different capacities. Since the cell internal resistance is significantly affected by temperature fluctuations, to reduce the impact of such fluctuations, the ambient temperature is able to be kept constant during adjustments to the test conditions. Instead, the external circuit resistance is able to be calculated by adjusting only the capacity. Under such conditions, the impact of the ambient temperature fluctuations on the calculation result is able to be minimized to the greatest extent, thereby enhancing the accuracy and reliability of the calculation result of the external circuit resistance. This approach effectively eliminates the ambient temperature-related influencing factor and enhances the accuracy of fault determination.

In an embodiment, a step of acquiring reference internal resistance of the cell under the reference temperature and reference capacity conditions includes: acquiring a current temperature and a current capacity of an battery cell within each battery module; and calculating the reference internal resistance of the cell under the reference capacity and reference temperature conditions: $R\_b\_i = p1 + p2 * Exp(-T\_b\_i / p3) * Exp(-SOC\_b\_i / p4)$, wherein $T\_b\_i$ represents an average current temperature of cells with a same serial number in all battery modules, and $SOC\_b\_i$ represents an average current capacity of the cells with the same serial number in all battery modules.

In this embodiment, an invention method during the actual battery detection process is provided. That is, a current temperature and a current capacity of each battery cell are acquired. Then, according to the current temperature and the current capacity, in combination with the relationship expression of the reference internal resistance $R\_b$ with respect to the reference temperature $T\_b$ and the reference capacity $SOC\_b$ above, the reference internal resistance of each cell under the reference capacity and reference temperature conditions is able to be calculated. Accordingly, the reference capacity that the cell is to exhibit under the current temperature and current capacity conditions is able to be acquired.

To improve the comparability of internal resistance of battery cells and enhance the accuracy of fault determination, all battery cells need to be compared under the same environmental and positional conditions. Therefore, battery cells with the same serial number in different battery modules need to be placed together for comparison. On the basis of this, the aforementioned relationship expression of the reference internal resistance R_b with respect to the reference temperature T_b and the reference capacity SOC_b needs to be adjusted, specifically: R_b_i = p1 + p2 * Exp(-T_b_i / p3) * Exp(-SOC_b_i / p4), wherein T_b_i represents an average current temperature of cells with a same serial number in all battery modules, and SOC_b_i represents an average current capacity of the cells with the same serial number in all battery modules.

In this way, the reference internal resistance refers to internal resistance that battery cells with the same serial number in different battery modules is expected to exhibit under the same temperature and positional conditions. Using this internal resistance as the reference internal resistance, the battery cells with the same serial number in different battery modules are able to be compared under the same temperature and positional conditions, thereby eliminating the impact of position and operating environments on the battery cells, and further enhancing the comparability of batteries. Furthermore, different battery cells are compared under the same conditions, which enhances the accuracy of the battery comparison, and enables precise detection of variation trends and magnitudes in internal resistance of different batteries at the same position. This is able to avoid incorrect and delayed battery fault determination, enable timely identification of a problematic battery cell before fault occurrence, and significantly enhance system safety.

In an embodiment, a step of comparing the actual cell internal resistances of the cells with a same serial number in different battery modules with reference internal resistances of the cells with the same serial number to obtain an internal resistance deviation value includes: sorting actual cell internal resistances $R_{tr}$ of cells i with a same serial number in all battery modules in ascending order, and acquiring a maximum value and a minimum value, R_tr_i_max and R_tr_i_min; and calculating a maximum internal resistance deviation value $MAX_i$ of actual cell internal resistances R_tr_i of cells i with a same serial number relative to the reference internal resistances R_b:

$$MAX_i = \max [|R\_tr\_i\_max - R\_b|, |R\_b - R\_tr\_i\_min|].$$

By comparing battery cells with the same serial number or in the same position within all battery modules, the impact of environmental factors and external circuitry on battery cells is able to be further eliminated. This ensures that all battery cells are situated under the same operating conditions, including temperature, SOC, and position, thereby further enhancing the comparability of internal resistance of the batteries and enhancing the accuracy of fault determination.

If the maximum internal resistance deviation value $MAX_i$ corresponding to the cell i exceeds the internal resistance deviation threshold, the cell i is determined to be faulty, and the corresponding battery module is identified. Otherwise, battery cells of all battery modules are determined to be normal.

The method for identifying the internal resistance consistency fault in the energy storage battery according to the embodiments of the present invention aims to address the problem of inaccurate determination of battery cell faults using voltage. Instead, internal resistance of battery cells is employed as the fault determination basis. Moreover, since internal resistance of the battery cells varies continuously and strongly influenced by the temperature and SOC, the method first calculates the external circuit resistance of the battery cell and eliminates the external circuit resistance from the collected data, thereby obtaining the actual internal resistance of the battery cells under current temperature and capacity conditions. Subsequently, through extensive experimental data on the battery cell, the relationship expression of the internal resistance of the battery cell with respect to the temperature and the capacity is obtained. According to the relationship expression, the reference internal resistance of the cell under the current reference temperature and the current reference capacity is determined. By applying this method, all battery cells are compared under the same reference temperature and reference capacity, and battery cells of a plurality of battery modules at the same position within an energy storage system are compared by combining the advantages of the energy storage system, thereby eliminating the impact of position and operating environments on the battery cells, and further enhancing the comparability of batteries. Furthermore, different battery cells are compared under the same conditions, which enhances the accuracy of the battery comparison, and enables precise detection of variation trends and magnitudes in internal resistance of different batteries at the same position. This is able to avoid incorrect and delayed battery fault determination, enable timely identification of a problematic battery cell before fault occurrence, and significantly enhance system safety.

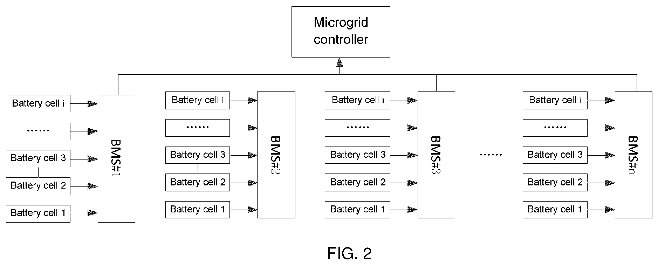

Referring to FIG. 2, according to embodiments of the present invention, an energy storage system applies the method for identifying an internal resistance consistency fault in an energy storage battery described above. The energy storage system includes: n battery modules connected in parallel, wherein each battery module includes a BMS and a plurality of cells, and the plurality of cells are connected in series and/or in parallel; and a microgrid controller communicatively connected with the BMS of the each battery, wherein the microgrid controller is configured to acquire battery module parameters collected by the BMS and to process the battery module parameters.

In this embodiment, the energy storage system includes n battery modules, each of which is composed of i cells connected in series and/or in parallel. Each battery module is equipped with the battery management system configured to collect cell voltage information. Each battery management system is electrically connected with the microgrid controller. The microgrid controller is configured to receive the cell voltage information and temperature information of all battery cells collected by the battery management system and to perform data processing and analysis. One microgrid controller corresponds to a plurality of battery management systems (BMS): BMS # 1 to BMS # n, and an upper limit of the cell internal resistance deviation value is set.

In an embodiment, the energy storage system further includes an energy storage converter, which is connected with all the battery modules and configured to control charging and discharging of the battery modules.

In an embodiment, the energy storage converter is electrically connected with the microgrid controller. When the microgrid controller detects a fault in the cells, the microgrid controller issues a shutdown command to the energy storage converter to stop charging and discharging the battery modules.

In an embodiment, all battery modules within the energy storage system are cooled using a liquid cooling method. In this case, the temperature differences between different modules are minimized. Compared with air cooling systems, liquid cooling is not affected by spatial positioning and provides superior cooling performance, enabling more effective control of battery temperature.

In an embodiment, the device for detecting the internal resistance of the cell during testing is an internal resistance tester. The method for detecting the internal resistance of the cell during module assembly is that the battery management system calculates the potential difference across two terminals of the cell to obtain the voltage, and then divides the voltage by the current to obtain the internal resistance.

In an embodiment, the BMS uses an STM32f4 series microcontroller, and the MC uses an ARM-A8 processor.

The embodiments of the present invention have the following advantages:

(1) The accuracy of fault determination is enhanced. Unlike the voltage-based determination method, in the present invention, the characteristic that the internal resistance of an battery cell increases before fault occurrence is utilized as the basis for fault determination. This method thoroughly accounts for various influencing factors of internal resistance and eliminates the external circuit resistance of the battery cell from the collected data. This enables precise calculation of the internal resistance of the battery cells, thereby enhancing the accuracy of fault determination and significantly enhancing system safety.

(2) The influence of temperature, capacity, and position is avoided. In the present invention, all battery cells are first compared under same temperature and capacity conditions to enhance the accuracy of internal resistance comparison. Furthermore, battery cells in the same position within all battery modules are compared to further eliminate the impact of position and operating environment on internal resistance. That is, all compared cells are able to be regarded as being under the same conditions, allowing the internal resistance variation behavior of the faulty cell to be clearly observed and enabling more accurate fault determination.

(3) Faulty cells are identified by comparing battery cells in the same position, which eliminates the influence of external environmental factors such as battery module grouping methods, temperature and humidity in the energy storage system cabin, and altitude. This reduces the difficulty and complexity of fault determination and provides a simple and effective fault determination method that is practical and easy to implement.

It is to be noted that the terms used herein are for describing specific embodiments only and are not intended to limit the exemplary embodiments according to the present invention. As used herein, unless the context clearly indicates otherwise, the singular form is also intended to comprise the plural form. In addition, it is to be understood that when the terms "include" and/or "comprise" are used in this description, the terms indicate the presence of features, steps, operations, devices, assemblies, and/or combinations thereof.

It is to be noted that the terms "first", "second", and the like in the description, claims, and drawings above of the present invention are used to distinguish similar objects, and are not necessarily used to describe a specific order or sequence. It is to be understood that the data used herein may be interchanged under appropriate circumstances, so that the embodiments of the present invention described herein can be implemented in sequences other than those illustrated or described.

The embodiments described above are merely some embodiments of the present invention and are not intended to limit the present invention. Various modifications and variations can be made by those skilled in the art. Any modification, equivalent replacement, improvement, and the like made within the spirit and principle of the present invention shall be comprised in the scope of protection of the present invention.

**Claims**

1. A method for identifying an internal resistance consistency fault in an energy storage battery, comprising:

   setting an upper limit of a cell internal resistance deviation threshold;
   determining a relationship expression of a reference internal resistance of a cell with respect to a reference temperature and a reference capacity of the cell;
   acquiring an external circuit resistance and current cell internal resistance of each battery cell;
   determining, according to the external circuit resistance and the current cell internal resistance of the each battery cell, an actual cell internal resistance of the each battery cell;
   acquiring the reference internal resistance of the cell under the reference temperature and reference capacity conditions;
   comparing actual cell internal resistances of cells with a same serial number in different battery modules with the reference internal resistances of the cell with the same serial number to obtain an internal resistance deviation value; and
   determining whether the internal resistance deviation value is greater than the cell internal resistance deviation threshold, and determining, in response to the internal resistance deviation value being greater than the cell internal resistance deviation threshold, that the cell is faulty.

2. The method for identifying the internal resistance consistency fault in the energy storage battery according to claim 1, wherein a step of determining the relationship expression of reference internal resistance of the cell with respect to the reference temperature and the reference capacity of the cell comprises:

   setting the reference temperature $T\_b$ and reference capacity $SOC\_b$ of the cell as two independent variables, and the reference internal resistance $R\_b$ of the cell as a dependent variable; and
   acquiring a relationship expression of the reference internal resistance $R\_b$ with respect to the reference temperature $T\_b$ and the reference capacity $SOC\_b$:

$$R\_b = p1 + p2 * Exp(-T\_b / p3) * Exp(-SOC\_b / p4),$$

   wherein p1, p2, p3, and p4 are constants obtained through experiments or empirical formulas.

3. The method for identifying the internal resistance consistency fault in the energy storage battery according to claim 2, wherein a step of acquiring the relationship expression of the reference internal resistance $R\_b$ with respect to the reference temperature $T\_b$ and the reference capacity $SOC\_b$ comprises:

   conducting evenly spaced experiments on the cell within a preset operating environment;
   varying, using a single temperature as a horizontal axis, the capacity at equal intervals, and
   measuring reference internal resistances at different capacities under the temperature;
   adjusting the temperature, varying the capacity at equal intervals again, and measuring reference internal resistances at different capacities under the temperature;
   repeating the steps above to obtain an array relationship table of the reference internal resistance $R\_b$ with respect to the reference temperature $T\_b$ and the reference capacity $SOC\_b$, a fundamental functional model thereof being:

$$R\_b = f(T\_b) * g(SOC\_b) + C,$$

   wherein C represents a constant; and
   using least squares method in matlab to fit experimental data to acquire the relationship expression of the reference internal resistance $R\_b$ with respect to the reference temperature $T\_b$ and the reference capacity $SOC\_b$.

4. The method for identifying the internal resistance consistency fault in the energy storage battery according to claim 1, wherein a step of acquiring the external circuit resistance of the each battery cell comprises:

   acquiring a tested cell internal resistance $R_i$ of the each battery cell under a same test condition;
   collecting a battery cell voltage set of the battery modules as $[V_{1i}, V_{2i}, V_{3i}, ..., V_{ni}]$, wherein n represents an n-th battery module, and i represents an i-th battery cell within a battery module; and

calculating the external circuit resistance of the battery cell as $R_{ni} = (V_{ni} - I_n * R_i) / I_n$, wherein $I_n$ represents a current of the battery cell in the n-th battery module.

5. The method for identifying the internal resistance consistency fault in the energy storage battery according to claim 4, wherein the step of acquiring the external circuit resistance of the each battery cell further comprises:

acquiring external circuit resistances of a same battery cell under β test conditions; and
calculating an average external circuit resistance as $Rni\_o = (Rni\_1 + Rni\_2 +...+ Rni\_\beta) / \beta$, and using $Rni\_o$ as the external circuit resistance of the i-th battery cell in the n-th battery module.

6. The method for identifying the internal resistance consistency fault in the energy storage battery according to claim 2, wherein a step of acquiring reference internal resistance of the cell under the reference temperature and reference capacity conditions comprises:

acquiring a current temperature and a current battery capacity of a battery cell within each battery module; and
calculating the reference internal resistance of the cell under the reference capacity and reference temperature conditions:

$$R\_b\_i = p1 + p2 * Exp(-T\_b\_i / p3) * Exp(-SOC\_b\_i / p4),$$

wherein $T\_b\_i$ represents an average current temperature of cells with a same serial number in all battery modules, and $SOC\_b\_i$ represents an average current capacity of the cells with the same serial number in all battery modules.

7. The method for identifying the internal resistance consistency fault in the energy storage battery according to claim 6, wherein a step of comparing the actual cell internal resistances of the cells with a same serial number in different battery modules with the reference internal resistances of the cells with the same serial number to obtain an internal resistance deviation value comprises:

sorting the actual cell internal resistances $R\_tr$ of cells i with a same serial number in all battery modules in ascending order, and acquiring a maximum value and a minimum value, $R\_tr\_i\_max$ and $R\_tr\_i\_min$; and
calculating a maximum internal resistance deviation value $MAXi$ of the actual cell internal resistances $R\_tr\_i$ of cells i with a same serial number relative to the reference internal resistances $R\_b$: $MAXi = max [|R\_tr\_i\_max - R\_b|, |R\_b - R\_tr\_i\_min|]$.

8. The method for identifying the internal resistance consistency fault in the energy storage battery according to claim 6, wherein β test conditions are test conditions formed under a same ambient temperature with β different capacities.

9. An energy storage system applying the method for identifying the internal resistance consistency fault in the energy storage battery according to any one of claims 1 to 8, wherein the energy storage system comprises:

n battery modules connected in parallel, wherein each battery module comprises a BMS and a plurality of cells, and the plurality of cells are connected in series and/or in parallel; and
a microgrid controller communicatively connected with the BMS of the each battery module, wherein the microgrid controller is configured to acquire battery module parameters collected by the BMS of the each battery and to process the battery module parameters.

10. The energy storage system according to claim 9, wherein the energy storage system further comprises an energy storage converter; the energy storage converter is connected with all of the battery modules and configured to control charging and discharging of the battery modules; and/or, the energy storage converter is electrically connected with the microgrid controller, wherein when the microgrid controller detects a fault in the cells, the microgrid controller issues a shutdown command to the energy storage converter to stop charging and discharging the battery modules.

setting an upper limit of a cell internal resistance deviation threshold

determining a relationship expression of a reference internal resistance of a cell with respect to a reference temperature and a reference capacity of the cell

acquiring an external circuit resistance and current cell internal resistance of each battery cell

determining, according to the external circuit resistance and the current cell internal resistance of the each battery cell, an actual cell internal resistance of the each battery cell

acquiring the reference internal resistance of the cell under the reference temperature and reference capacity conditions

comparing actual cell internal resistances of cells with a same serial number in different battery modules with the reference internal resistances of the cell with the same serial number to obtain an internal resistance deviation value

determining whether the internal resistance deviation value is greater than the cell internal resistance deviation threshold, and determining, in response to the internal resistance deviation value being greater than the cell internal resistance deviation threshold, that the cell is faulty

FIG. 1

FIG. 2

## INTERNATIONAL SEARCH REPORT

| International application No. |
| --- |
| **PCT/CN2023/114787** |

| A. | CLASSIFICATION OF SUBJECT MATTER |
| --- | --- |

G01R31/389(2019.01)i;  G01R31/392(2019.01)i;  H02J7/34 (2006.01)i

According to International Patent Classification (IPC) or to both national classification and IPC

| B. | FIELDS SEARCHED |
| --- | --- |

Minimum documentation searched (classification system followed by classification symbols)

IPC:G01R31,H02J7

Documentation searched other than minimum documentation to the extent that such documents are included in the fields searched

Electronic data base consulted during the international search (name of data base and, where practicable, search terms used)

CNABS, CNTXT, CNKI, ENTXTC, VEN: 电池, 电芯, 内阻, 内电阻, 内部电阻, 内部阻抗, 外, 电阻, 阻抗, 偏移, 偏离, 偏差, 一致性, BATTERY, CELL, UNIFORM+, CONSISTENCY, INTERNAL, RESISTANCE, EXTERNAL

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 116203446 A (HEFEI GUOXUAN HIGH-TECH POWER ENERGY CO., LTD.) 02 June 2023 (2023-06-02)<br>claims 1-10 | 1-10 |
| Y | CN 105866701 A (SHANGHAI ELECTRIC SODIUM SULFUR ENERGY STORAGE TECHNOLOGY CO., LTD.) 17 August 2016 (2016-08-17)<br>description, paragraphs 29-77, and figure 1 | 1-10 |
| Y | CN 114200331 A (GUANGZHOU XIAOPENG MOTORS TECHNOLOGY CO., LTD.) 18 March 2022 (2022-03-18)<br>description, paragraphs 63-81, and figures 1-2 | 1-10 |
| A | CN 107861064 A (MINMAX ENERGY TECHNOLOGY CO., LTD.) 30 March 2018 (2018-03-30)<br>entire document | 1-10 |
| A | CN 110554329 A (NEUSOFT REACH AUTOMOTIVE TECHNOLOGY (SHENYANG) CO., LTD.) 10 December 2019 (2019-12-10)<br>entire document | 1-10 |

| ✓ Further documents are listed in the continuation of Box C. | ✓ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **16 November 2023** | **04 December 2023** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/114787** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 113238158 A (ZHANGJIAGANG TSINGYAN TESTING TECHNOLOGY CO., LTD.) 10 August 2021 (2021-08-10)<br>    entire document | 1-10 |
| A | CN 115327409 A (SUNGROW POWER SUPPLY CO., LTD.) 11 November 2022 (2022-11-11)<br>    entire document | 1-10 |
| A | KR 20160040887 A (LG CHEM, LTD.) 15 April 2016 (2016-04-15)<br>    entire document | 1-10 |
| A | KR 20190035441 A (POSCO ICT CO., LTD.) 03 April 2019 (2019-04-03)<br>    entire document | 1-10 |

Form PCT/ISA/210 (second sheet) (July 2022)

**INTERNATIONAL SEARCH REPORT**
Information on patent family members

International application No.

**PCT/CN2023/114787**

| Patent document cited in search report | | | Publication date (day/month/year) | Patent family member(s) | | | Publication date (day/month/year) |
|---|---|---|---|---|---|---|---|
| CN | 116203446 | A | 02 June 2023 | None | | | |
| CN | 105866701 | A | 17 August 2016 | None | | | |
| CN | 114200331 | A | 18 March 2022 | None | | | |
| CN | 107861064 | A | 30 March 2018 | None | | | |
| CN | 110554329 | A | 10 December 2019 | None | | | |
| CN | 113238158 | A | 10 August 2021 | None | | | |
| CN | 115327409 | A | 11 November 2022 | None | | | |
| KR | 20160040887 | A | 15 April 2016 | KR | 101739169 | B1 | 23 May 2017 |
| KR | 20190035441 | A | 03 April 2019 | KR | 101989692 | B1 | 14 June 2019 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310215706